# EUROPÄISCHE PATENTSCHRIFT

(11) **EP 2 552 824 B1**
(45) Veröffentlichungstag und Bekanntmachung des Hinweises auf die Patenterteilung: **21.05.2014**
(21) Anmeldenummer: 11709909.3
(22) Anmeldetag: 15.03.2011
(51) Int. Cl.: B81B 3/00

(54) **MIKROELEKTROMECHANISCHE VORRICHTUNG UND IHRE VERWENDUNG**
MICRO-ELECTROMECHANICAL DEVICE AND USE THEREOF
DISPOSITIF MICROÉLECTROMÉCANIQUE ET SON UTILISATION

(30) Priorität: 26.03.2010 EP 10157917
(43) Veröffentlichungstag der Anmeldung: 06.02.2013
(73) Patentinhaber: ELMOS Semiconductor AG, 44227 Dortmund (DE); Silicon Microstructures, Inc., Milpitas, CA 95035 (US)
(72) Erfinder: BURCHARD, Bernd, 44227 Dortmund (DE); DOELLE, Michael, Milpitas, California 95035 (US); NINGNING, Zhou, Milpitas, California 95035 (US)
(74) Vertreter: Von Kreisler Selting Werner - Partnerschaft von Patentanwälten und Rechtsanwälten mbB
(86) Internationale Anmeldenummer: PCT/EP2011/053840
(87) Internationale Veröffentlichungsnummer: WO 2011/117105

(56) Entgegenhaltungen:
- WO-A1-2009/087055
- WO-A2-2006/081888
- US-A1- 2002 044 327
- US-A1- 2004 020 292
- US-B1- 6 426 013
- DIBI Z ET AL: "Combined effect of the membrane flatness defect and real dimensions gauges on the sensitivity of a silicon piezoresistive pressure sensor", PROCEEDINGS OF IEEE SENSORS 2002. ORLANDO, FL, JUNE 12 - 14, 2002; [IEEE INTERNATIONAL CONFERENCE ON SENSORS], NEW YORK, NY : IEEE, US, Bd. 2, 12. Juni 2002 (2002-06-12), Seiten 990-993, XP010605244, DOI: DOI:10.1109/ICSENS.2002.1037245 ISBN: 978-0-7803-7454-6

## Beschreibung

Die Erfindung betrifft im Allgemeinen eine zu herkömmlichen Halbleiterelement-Herstellungsprozessen kompatible mikroelektromechanische Vorrichtung mit niedriger Fertigungsstreuung. Eine spezielle beispielhafte Ausprägung der Erfindung ist ein mikromechanischer CMOS-Drucksensor mit niedriger Fertigungstreuung.

Aus US-B-6 426 013 ist eine mikroelektronische Vorrichtung mit einem für die Herstellung mikroelektronischer Bauelemente geeigneten Substrat, insbesondere Halbleitersubstrat, und einem in das Substrat integrierten mikromechanischen Bauelement bekannt, das ein reversibel verbiegbares Biegeelement aufweist, welches ein mit dem Substrat verbundenes erstes Ende aufweist und sich von diesem ersten Ende aus über einen Freiraum erstreckt. Das Biegeelement weist mindestens einen Steg mit zwei Seitenrändern auf, deren Verlauf durch an die Seitenränder angrenzende, in das Biegeelement eingebrachte Vertiefungen definiert ist. Der gegenseitige Abstand der Seitenränder des Steges nimmt, von dem ersten Ende des Biegeelements aus betrachtet, ab. Ferner weist die bekannte Vorrichtung mindestens ein für mechanische Spannungen empfindliches mikroelektronisches Bauelement auf.

Bei mikroelektromechanischen Vorrichtungen ist die exakte relative Positionierung von in einem Halbleitersubstrat integrierten elektronischen Bauelementen, insbesondere piezo-resistiven Widerständen oder Transistoren, zu ebenfalls in dem Halbleitersubstrat integrierten mikromechanischen Strukturen für die ordnungsgemäße Funktion der Vorrichtung von großer Bedeutung. Derartige mikroelektromechanische Vorrichtungen weisen mikromechanische Bauelemente auf, deren Funktion beispielsweise durch mechanische Materialspannungen einerseits beabsichtigt, also konstruktiv bedingt, andererseits aber auch parasitär beeinflusst ist. Typischerweise werden die elektronischen sowie mikromechanischen Bauelemente in der Mikroelektromechanik planar durch Photolithographie hergestellt. Die mikromechanischen Bauelemente können beispielsweise allseitig eingespannte aber auch nicht allseitig eingespannte Platten, Membranen und Balken sowie auch komplexere Formen aufweisen. Als Beispiele für derartige mikromechanische Bauelemente können hier einseitig eingespannte Balken (Beams, Cantilever) für schwingende Systeme, Druckmembranen für Druck-Sensoren, oder zentral gelagerte Kreisscheiben für Oszillatoren genannt werden.

Die mikromechanische Fertigung dieser mikromechanischen Bauelemente bzw. Strukturen ist bezogen auf die absoluten Dimensionen der mikromechanischen Bauelemente, die typischerweise im µm- oder maximal mm-Bereich liegen, mit wesentlich höheren relativen Fertigungstoleranzen behaftet als dies bei konventioneller Nicht-Mikromechanik der Fall ist. Dabei ist bei der Gestaltung der Herstellungsprozesse besonders darauf Wert zu legen, dass die Auslegung und Fertigungsmethodik so gewählt wird, dass die sich ergebende Prozesskonstruktion hinsichtlich des Prozessresultats (nämlich der mikroelektromechanischen Vorrichtung) robust auf die besagten unvermeidbaren Parameterschwankungen reagiert. Hierbei steht die Konstruktion der herzustellenden Vorrichtung Hand in Hand mit der Prozesskonstruktion; beide sind nicht vollständig trennbar.

Insbesondere bei den beispielhaft hier beschriebenen Drucksensoren war es in der Vergangenheit üblich, das Design eines verformbaren Biegeelements so zu wählen, dass ein lokaler Bereich maximaler Materialspannungen entsteht, in dem das für mechanische Spannungen empfindliche Sensorelement platziert wird, damit man ein maximales Messsignal erhält. Die Erstreckung des Bereichs maximaler Materialspannungen ist nur gering, so dass durch die Fertigungstoleranzen bedingte Fehlplatzierungen des Sensorelements starke Nichtlinearitäten und Offset-Schwankungen zur Folge haben. Dies wiederum führt zu einem Kalibrations- und Testaufwand, der bis zu etwa 3/4 der Herstellungskosten von mikromechanischen Drucksensorsystemen zusätzlich zu den Herstellungskosten des Sensors selbst ausmachen kann.

Aufgabe der Erfindung ist es, bei solchen mikromechanischen Bauelementen, bei denen ein Materialspannungsfeld funktional oder parasitär von Bedeutung ist, dieses Materialspannungsfeld derart zu kontrollieren, dass die Auswirkungen besagter Fertigungsschwankungen auf die messtechnische Erfassung der Materialspannungen minimiert sind.

Zur Lösung dieser Aufgabe wird mit der Erfindung eine mikroelektromechanische Vorrichtung vorgeschlagen, die versehen ist mit den Merkmalen des Anspruchs 1. Verschiedene Ausgestaltungen der Erfindung sind Gegenstand der Unteransprüche.

Wesensmerkmal der erfindungsgemäßen mikroelektromechanischen Vorrichtung ist die Modellierung des Materialspannungsfeldes innerhalb eines reversebel verbiegbaren Biegeelements, so dass innerhalb dieses Materialspannungsfeldes die auftretenden Materialspannungen im Wesentlichen gleich sind. Dies gelingt erfindungsgemäß durch Verringerung der Breite des Steges in einem Abschnitt seiner Längserstreckung vom eingespannten ersten Ende bis zum frei bewegbaren zweiten Ende. Der Steg ist Teil des Biegeelements und durch Seitenränder definiert, die durch beidseitig des Steges ausgebildete, in das Biegeelement eingebrachte Vertiefungen definiert sind. An seinem am Substrat angebundenen ersten Ende weist das Biegeelement also beidseitig des Steges eine geringere Dicke als im Bereich des Steges auf. Der Steg selbst nimmt vom ersten Ende des Biegeelements aus betrachtet in seiner Breite ab, was kontinuierlich, quasi kontinuierlich oder stufenweise bzw. abschnittsweise kontinuierlich, abschnittsweise quasi kontinuierlich erfolgen kann. Die den Verlauf eines Seitenrandes des Steges beschreibende Funktion kann linear, quadratisch, exponentiell, stetig, stetig monoton, differenzierbar, abschnittsweise stetig, abschnittsweise stetig monoton oder abschnittsweise differenzierbar sein. Andere Funktionsverläufe sind ebenfalls möglich. Entscheidend ist, dass sich die Breite des Steges innerhalb desjenigen Bereichs, in dem der Homogenisierungsbereich entstehen soll, verringert, je größer die Entfernung vom eingespannten ersten Ende des Biegeelements bzw. des Steges wird. Der Verlauf längs beider Seitenränder des Steges ist zweckmäßigerweise bezogen auf eine Mittellinie des Steges symmetrisch.

Bei dem Biegeelement kann es sich beispielsweise um einen einseitig eingespannten freitragenden Balken, einen zweiseitig eingespannten Balken, einen mehrseitig eingespannten Balken bzw. eine Membran, Scheibe o.dgl. handeln. Sämtlichen Biegeelementen gemeinsam ist, dass sie einer reversiblen Verbiegung unterworfen sind, wenn auf sie Kräfte oder Drücke einwirken.

Durch den erfindungsgemäßen Ansatz, das für Materialspannungen empfindliche Sensorelement nicht mehr notwendigerweise im extrem eng begrenzten Bereich maximaler Materialspannungen anzuordnen, sondern vielmehr das Biegeelement geometrisch derart auszugestalten, dass innerhalb des Steges ein vergleichsweise großflächiger Bereich entsteht, in dem der Materialspannungsgradient im Wesentlichen null ist, kommt es nun auf eine genaue Platzierung des Sensorelements insoweit nicht mehr an, als von diesem Sensorelement lediglich verlangt wird, dass es zumindest teilweise, vorzugsweise aber vollständig innerhalb des Homogenisierungsbereichs liegt. Damit wirken sich nun also fertigungstoleranzbedingte Fehlplatzierungen des Sensorelements nicht mehr nachteilig auf Fertigungsstreuungen o.dgl. aus. Zudem können aufwendige Kalibrations- und Testverfahren im Anschluss an die Herstellung der mikroelektromechanischen Vorrichtung entfallen oder kostensparend reduziert werden.

Bei einer speziellen Anordnung der erfindungsgemäßen mikroelektromechanischen Vorrichtung ist der Homogenisierungsbereich in Breiten- oder Längenerstreckung des Steges ausgedehnt. Ferner kann vorgesehen sein, dass der Homogenisierungsbereich in Breiten- und/oder Längenerstreckung des Steges um einen vorgebbaren Mindestfaktor größer ist als die Ausdehnung des mikroelektronischen Bauelements in der betreffenden Breiten- und/oder Längenerstreckung des Steges. Beispielsweise kann der Faktor mindestens sechs Sigma betragen, wobei Sigma die durch den Prozess zur Fertigung mikroelektronischer Bauelemente definierte Platzierungsgenauigkeit des in dem Homogenisierungsbereich angeordneten mikroelektronischen Bauelement gegenüber der Lage dieses Homogenisierungsbereichs ist.

Das Biegeelement der erfindungsgemäßen mikroelektromechanischen Vorrichtung kann durch Ätzung des Substrats, insbesondere DRIE- oder Plasma-Ätzung ausgebildet sein. Anwendungsbeispiele der erfindungsgemäßen Vorrichtung sind ein Drucksensor, ein Beschleunigungssensor oder ein Resonator.

Die Erfindung wird zunächst anhand eines erfindungsgemäßen Drucksensors und unter Bezugnahme auf die Zeichnung erläutert. Im Einzelnen zeigen:
- Fig. 1: einen schematischen Querschnitt durch einen beispielhaften erfindungsgemäßen mikromechanischen Drucksensor,
- Fig. 2: eine Aufsicht auf einen Drucksensor nach dem Stand der Technik,
- Fig. 3: die mechanischen Spannungsverhältnisse in Abhängigkeit vom Radius in einem beispielhaften Drucksensor nach dem Stand der Technik,
- Fig. 4: einen idealisierten Spannungsverlauf für einen optimierten erfindungsgemäßen Drucksensor mit Plateau- oder Konstantbereich, was die fertigungsstabile Platzierung stressempfindlicher elektronischer Bauteile, z.B. piezoresistiver Widerstände oder MOS-Transistoren, erlaubt,
- Fig. 5: eine Aufsicht auf einen beispielhaften Drucksensor mit optimierten Stegen (Biegebalken bzw. Biegeelementen),
- Fig. 6: eine Aufsicht auf einen beispielhaften Drucksensor mit optimierten Stegen, wobei das Detail schematisch die optimierte Kurve der Stegberandung zeigt, die zu einem konstanten mechanischen Stress und damit zu dem gewünschten Stressplateau ähnlich dem gemäß der Kurve in Fig. 4 führt,
- Fig. 7: zusätzlich zu Fig. 6 schematisch die ungefähre Lage eines stressempfindlichen elektronischen Bauelementes im Bereich im Wesentlichen konstanter mechanischer Materialspannung auf dem Steg und
- Fig. 8: beispielhaft anhand eines Cantilevers die Übertragung der Erfindung auf andere Mikrostrukturen, wobei der Cantilever zum besseren Verständnis in der Seitenansicht und in der Aufsicht dargestellt ist.

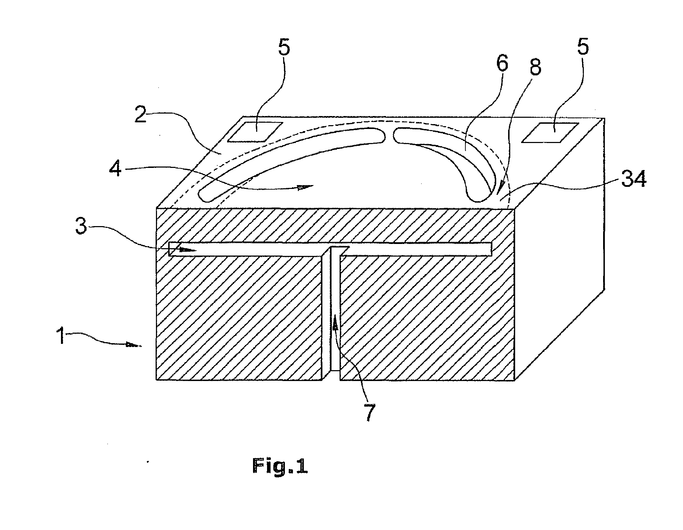

Fig. 1 zeigt schematisch einen Differenzdrucksensor auf Siliziumbasis (Si-Substrat) als ein Bespiel für eine Verkörperung der Erfindung.

In den Drucksensorkörper aus einem (Halbleiter-)Substrat 1 ist eine Kavität 3 eingebracht, über die sich an der Oberseite 2 des Substrats 1 eine Membran 4 erstreckt. In die Membran 4 sind von oben in die Oberseite 2 des Substrats 1 Gräben 6 eingeätzt, die die Membran 4 jedoch nicht durchbrechen. Die Gräben 6 sind von Stegen bzw. Balken 8 unterbrochen. Die Membran 4, die Gräben 6 und die Stege bzw. Balken 8 bilden ein reversibel verbiegbares Biegeelement; die messtechnische Erfassung der Verbiegung und damit der Kraft- bzw. Druckeinwirkung auf das Biegeelement erfolgt durch Messung der mechanischen Spannungen, denen beispielsweise einer der Stege ausgesetzt ist.

Um mit dem Drucksensor einen Differenzdruck messen zu können, wird die Kavität 3 über einen Kanal 7 mit der Umgebung verbunden. Für Absolutdruckmessungen müsste die Kavität 3 vollständig gegenüber der Umgebung abgeschlossen sein.

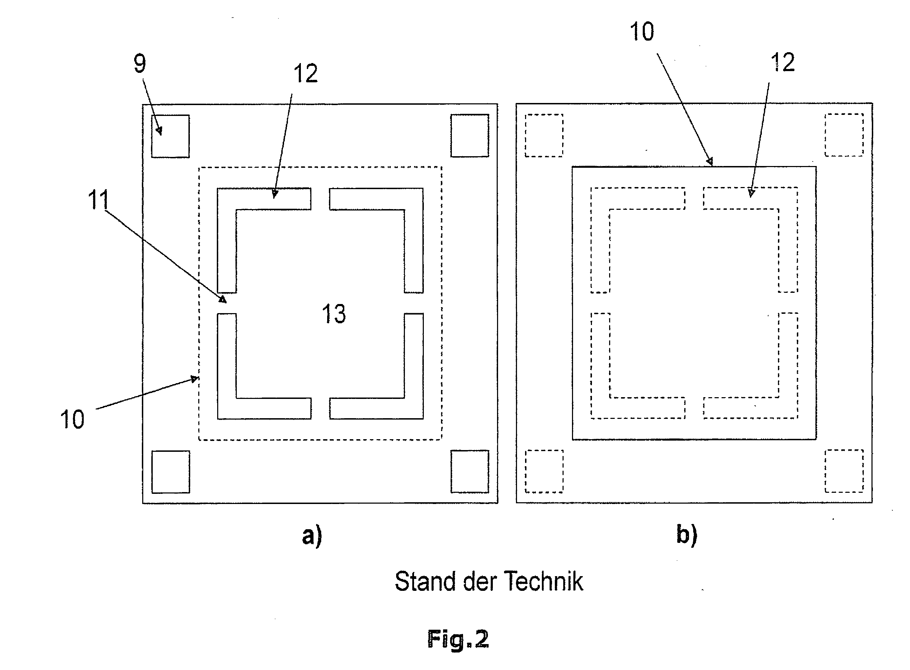

Fig. 2 zeigt die Aufsicht auf einen Drucksensor, wie er dem Stand der Technik entspricht. Wie der beschriebene erfindungsgemäße Drucksensor besitzt der bekannte Drucksensor eine unter der Sensoroberseite liegende Kavität, die von einer Membran 13 überdeckt ist. Wie beim Sensor gemäß Ausführungsbeispiel der Erfindung sind Gräben 12 in die Oberseite eingebracht. Der bekannte Sensor ist, wie übrigens auch der Sensor gemäß Ausführungsbeispiel, über Pads 9 elektrisch angeschlossen. Weitere Details, wie beispielsweise die eigentlichen Sensorelemente, sind in Fig. 2 nicht eingezeichnet. Nach dem Stand der Technik sind die Stege 11 als Balken konstanter Breite oder als Balken konstanten Winkels bezogen auf das Sensorzentrum ausgeführt.

Im Gegensatz zum bekannten Sensor nachdem Stand der Technik gemäß Fig. 2 ist die Breite der Balken bzw. Stege 8 bei dem erfindungsgemäßen Sensor so moduliert, dass der bei einer Verbiegung eines Balkens auftretende mechanische Stress zumindest in einem Teilbereich des Balkens bei idealer Ausführung konstant und bei realer Ausführung nahezu konstant ist.

Das bedeutet, dass das Stressfeld im Balken durch dessen Querschnitt moduliert und kontrolliert wird. Soll nun ein Sensor auf dem Balken platziert werden, so ist es aus fertigungstechnischen Gesichtspunkten eben nicht sinnvoll, wie heute üblich, den Stress zu maximieren, sondern auftretenden mechanischen Stress innerhalb eines Bereichs des Balkens im Sinne einer Homogenisierung so zu stabilisieren, dass auch bei den unvermeidlichen Platzierungsfehlern des Stress-sensitiven Elementes der mechanische Stress, dem das besagte Stress-sensitive Element ausgesetzt ist, unabhängig von der erzielten Platzierung sich möglichst nicht unterscheidet.

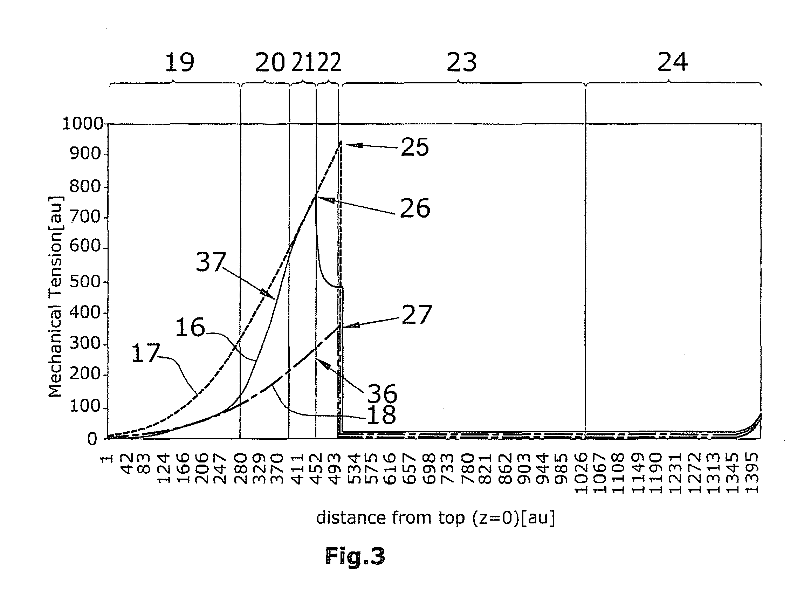

Fig. 3 zeigt den durch vereinfachte analytische Rechnung gemittelten Stressverlauf in der Membran eines Drucksensors nach dem Stand der Technik. Wird die gesamte Membranfläche um die Grabentiefe abgedünnt, so ist der Stress in der so enthaltenen Membran besonders hoch und folgt der oberen Kurve 17,37. Wird kein Graben geätzt, so folgt der mittlere mechanische Stress in etwa der unteren Kurve 18,36. Die Kurve eines Sensors mit einer Aufsicht ähnlich der gemäß Fig. 2 folgt in etwa der Kurve 18 und bewegt sich zwischen den beiden Extremen. Im Bereich 19, dies ist der Bereich des Zentrums der Drucksensor-Membrane 13, folgt die Spannung der unteren Kurve 36. Wird der Radius des betrachteten Schnittkreises so groß, dass der Schnittkreis nicht mehr vollständig innerhalb der Drucksensor-Membrane 13 liegt, sondern den Bereich des Grabens 12 schneidet, so beginnt der mittlere mechanische Stress im Abstandsbereich 20 vom Zentrum so lange zu steigen, bis der Schnittkreis vollständig im Graben 12 liegt und die Kurve im Bereich 21 nun der Kurve 37 folgt. Dies geschieht so lange, bis der Radius so groß ist, dass der Schnittkreis größer als der Graben 12 ist. Dann fällt der mechanische Stress im Abstandsbereich 22 vom Zentrum wieder ab, bis er wieder die Kurve 36 trifft oder, wie hier, bis der Schnittkreis auch die Kavität 10 verlässt. In diesem Fall kommt es dann zu einem massiven Abfall des mechanischen Stresses, da dann der gesamte Körper des Sensors den Rest-Stress aufnehmen kann (siehe Abstandsbereiche 23 und 24 vom Zentrum).

Nachteilig ist, dass der mechanische Stress in den Abstandsbereichen 19 bis 22 vom Zentrum niemals konstant ist. Damit wirken sich Platzierungsungenauigkeiten Stress-sensitiver Bauelemente, beispielsweise piezoresistiver Widerstände, massiv auf die Systemperformance und die resultierenden Fertigungsunterschiede aus.

Insbesondere eine Platzierung an den Maxima 25,26,27 der Stresskurven ist fertigungstechnisch äußerst ungünstig, da die Ableitung des mechanischen Stresses nach dem Radius maximal ist und daher dort die größte Empfindlichkeit gegen Fertigungsschwankungen besteht.

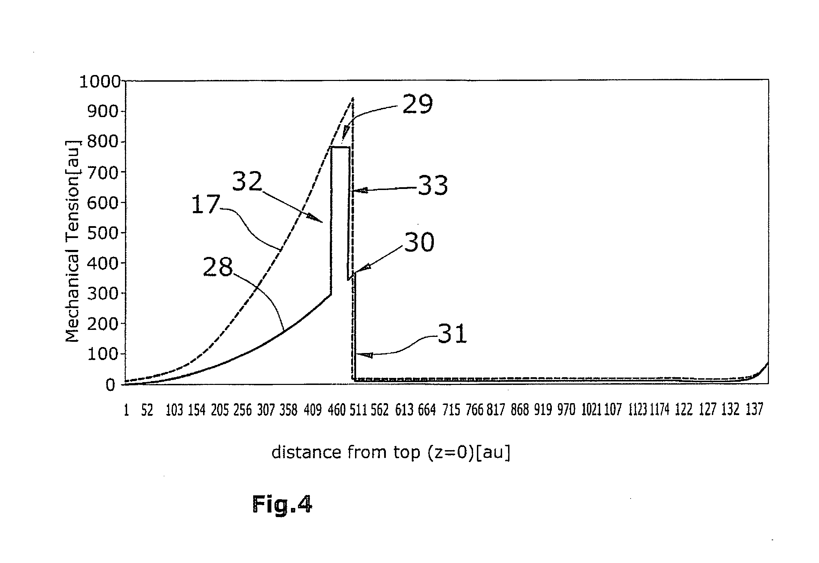

Fig. 4 zeigt einen beispielhaften, wünschenswerten Stressverlauf 28, wobei in Fig. 4 auch nochmals der Verlauf der Kurve 17 von Fig. 3 eingezeichnet ist. Der Stressverlauf 28 zeichnet sich durch einen raschen Anstieg 32 und einen steilen Abfall 33 sowie - und dies ist der wesentliche Punkt - ein zwischen beiden liegendes erfindungsgemäßes Plateau 29 gleichbleibenden Stresses aus, dessen Lage so gewählt ist, dass bei typischerweise bekannten Platzierungsungenauigkeiten die Größe des Bauelementes um 3 Sigma zu beiden Seiten kleiner ist als das Plateau 29. Hierdurch wird sichergestellt, dass das Bauteil bezüglich dieses Zusammenhangs mit einem Cpk-Wert von 2 gefertigt werden kann. Da die Kavität 3 in der Regel nicht mit besonders guter Platzierungsgenauigkeit gegenüber Strukturen auf der Vorderseite gefertigt werden kann, ist es sinnvoll, den ersten Stressabfall 33 in einem gewissen Abstand von 3 Sigma dieser Platzierungsgenauigkeit vor der Kavitätsgrenze erfolgen zu lassen (siehe bei 30 in Fig. 4), an der der weitere Stressabfall 31 erfolgt.

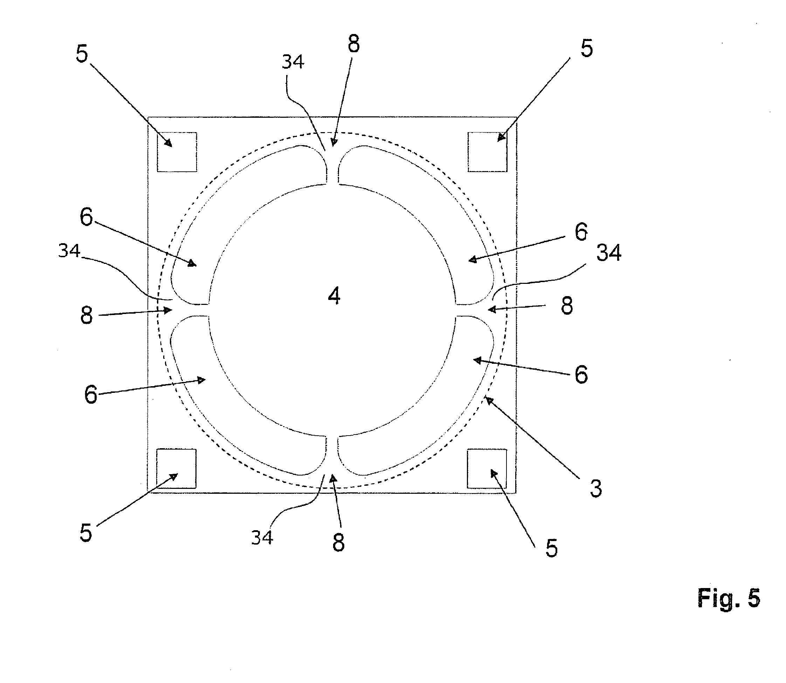

Der beispielhafte erfindungsgemäße Drucksensor ist schematisch in Fig. 5 in der Aufsicht dargestellt. Die Membran 4 ist hier kreisrund und die Gräben 6 verlaufen gekrümmt und längs des Umfangs der Membran 4. Die Erfindung ist aber auch bei einer rechteckigen Membran mit winkligem Grabenverlauf, wie in Fig. 2 gezeigt, anwendbar.

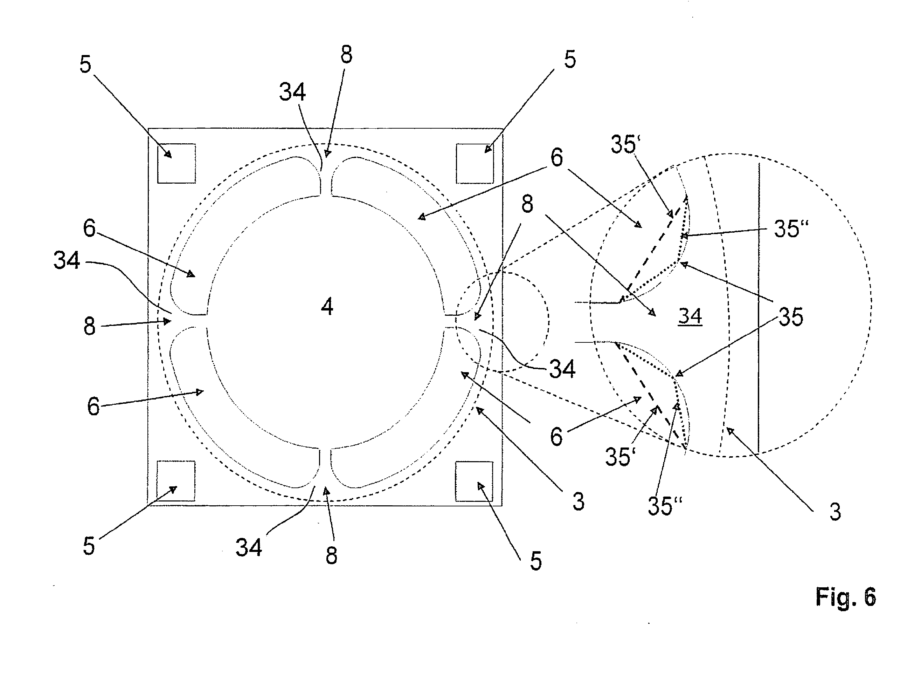

In Fig. 6 ist der wesentlich Punkt der Erfindung basierend auf Fig. 5 noch einmal rechts vergrößert dargestellt: Durch eine geeignete Form 35 der Seitenränder der Stege 8, die die Gräben 6 unterbrechen, wird der Querschnitt jedes Stegs 8 so in Abhängigkeit vom Radius (Abstand vom Mittelpunkt der Drucksensor-Membrane) verändert, dass sich bei Auslenkung der Membran im Bereich der (Kurven-)Form 35 ein konstantes Stressprofil (siehe Plateau 29 in Fig. 4) ergibt. Die "Anbindung" der Stege 8 an das Bulk-Silizium (siehe in Fig. 1 die Bereiche radial außerhalb der Kavität 3), d.h. die Ausgestaltung jedes Steges 8 an dessen ersten Ende 34 ist derart gewählt, dass sich die Breite des Steges 8 zum ersten Ende 34 hin vergrößert, d.h. in Richtung auf das Zentrum der Membran 4 hin verkleinert. Dies erfolgt in diesem Ausführungsbeispiel durch bezogen auf den Steg 8 seitlich nach außen auslaufende kurvenförmige Randabschnitte (siehe den Verlauf bei 35) der Gräben 6. Alternativ könnten sich diese Randabschnitte auch geradlinig schräg, stufenförmig oder polygonal nach außen erstrecken. Mit anderen Worten kann die (Kurven-)Form 35 auch durch geradlinige Abschnitte oder Stufen angenähert sein (siehe die verschiedenen in Fig. 6 gestrichelt eingezeichneten Verläufe 35',35").

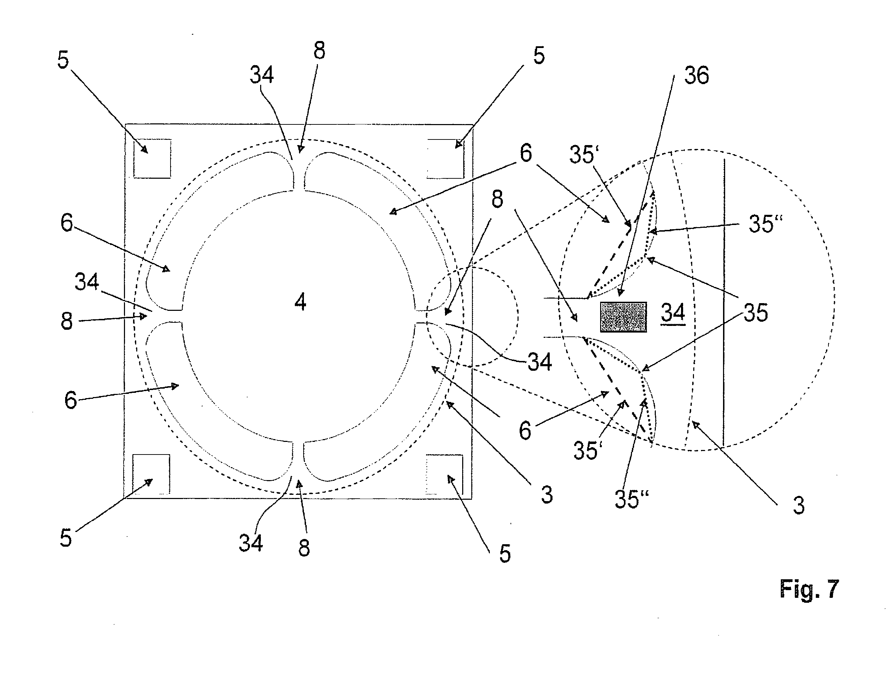

Fig. 7 zeigt eine beispielhafte, schematische Platzierung eines stressempfindlichen elektronischen Bauelementes im Verhältnis zum Steg und dessen Modellierungskurven-Form 35.

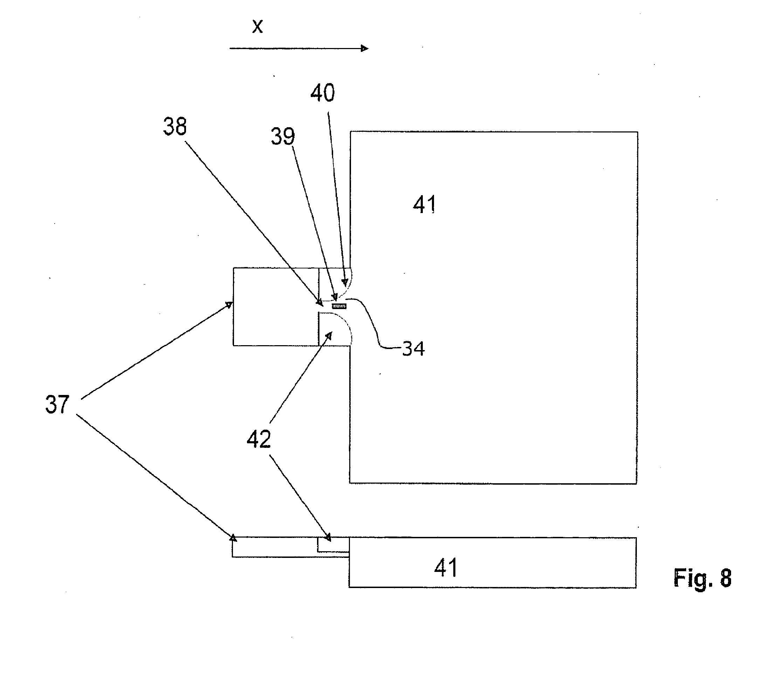

Das Prinzip eines solchermaßen modulierten Profils eines Steges kann selbstverständlich auch in anderen Sensoren eingesetzt werden. So ist es zum Beispiel denkbar dies in Cantilevern und Resonatoren einzusetzen. Fig. 8 zeigt schematisch eine beispielhafte Ausführung der Erfindung in Zusammengang mit einem Cantilever 37. Der Cantilever ist im Bereich des stressempfindlichen elektronischen Bauelementes 39 in der Dicke modelliert. Der Cantilever verfügt in diesem Bereich über ausgedünnte Bereiche 42 und unveränderte Bereiche 38. Die Grenzkurve 40 zwischen den ausgedünnten Bereichen 42 und dem nicht gedünnten Bereich 38 ist dabei wieder so gewählt, dass eine bestimmungsgemäße Krafteinwirkung auf den Cantilever 37 zu einer ebenso bestimmungsgemäßen Auslenkung desselben 37 gegenüber dem Sensor-Bulk 41 führt und dass diese Auslenkung wiederum zu einem in x-Richtung (siehe Markierung in Fig. 8) nahezu konstanten mechanischen Stress im Bereich des stressempfindlichen elektronischen Bauelementes 39 führt.

Kommt es nun zu Fertigungsfehlern, die zu einer Verschiebung der elektronischen Bauteile gegenüber den mikromechanischen Strukturen führen, so hat diese Verschiebung keinen Effekt, wenn dass Stressfeld konstant ist und der Bereich der Konstanz nicht verlassen wird. Ist das Stressfeld nahezu konstant, so führt die Verschiebung nur zu einem sehr kleinen Effekt verglichen mit einer Lösung entsprechend dem Stand der Technik. Somit wird durch eine derartige Stressfeldmodulation das Ziel einer besseren Fertigungstauglichkeit erreicht.

Es ist zweckmäßig, die entsprechenden Strukturen durch DRIE- oder Plasma-Ätzung herzustellen, da diese eine freie Wahl der Formen gestattet.

## Patentansprüche

1. Mikroelektromechanische Vorrichtung mit
- einem für die Herstellung mikroelektronischer Bauelemente geeigneten Substrat (1), insbesondere Halbleitersubstrat,
- einem in das Substrat (1) integrierten mikromechanischen Bauelement, das ein reversibel verbiegbares Biegeelement (4) aufweist, welches ein mit dem Substrat (1) verbundenes erstes Ende (34) aufweist und sich von diesem ersten Ende (34) aus über einen Freiraum (3) erstreckt,
- wobei das Biegeelement (4) mindestens einen Steg (8) mit zwei Seitenrändern aufweist, deren Verlauf (35) durch an die Seitenränder angrenzende, in das Biegeelement (4) eingebrachte Vertiefungen (6) definiert ist, und
- wobei der gegenseitige Abstand der Seitenränder des Steges (8) von dem ersten Ende (34) des Biegeelements (4) aus betrachtet abnimmt, und
- mindestens einem für mechanische Spannungen empfindlichen mikroelektronischen Bauelement (36),
**dadurch gekennzeichnet,**
- **dass** der gegenseitige Abstand der Seitenränder des Steges (8) von dem ersten Ende (34) des Biegeelements (4) aus betrachtet zur Bildung eines innerhalb des Steges (8) liegenden Homogenisierungsbereichs, in dem beim Verbiegen des Biegeelements (4) auftretende mechanische Spannungen im Wesentlichen gleich groß sind, abnimmt und
- **dass** das mindestens eine für mechanische Spannungen empfindliche mikroelektronische Bauelement (36) innerhalb des Homogenisierungsbereichs des Steges (8) integriert ist.

2. Mikroelektromechanische Vorrichtung nach Anspruch 1, **dadurch gekennzeichnet, dass** der Homogenisierungsbereich in Breiten- oder Längenerstreckung des Steges (8) ausgedehnt ist.

3. Mikroelektromechanische Vorrichtung nach Anspruch 1 oder 2, **dadurch gekennzeichnet, dass** das mikroelektronische Bauelement (36) vollständig innerhalb des Homogenisierungsbereichs des Steges (8) angeordnet ist.

4. Mikroelektromechanische Vorrichtung nach einem der Ansprüche 1 bis 3, **dadurch gekennzeichnet, dass** der Homogenisierungsbereich in Breiten- und/oder Längenerstreckung des Steges (8) um einen vorgebbaren Mindestfaktor größer ist als die Ausdehnung des mikroelektronischen Bauelements (36) in der betreffenden Breiten- und/oder Längenerstreckung des Steges (8).

5. Mikroelektromechanische Vorrichtung nach Anspruch 4, **dadurch gekennzeichnet, dass** der Faktor mindestens sechs Sigma beträgt, wobei Sigma die durch den Prozess zur Fertigung mikroelektronischer Bauelemente definierte Platzierungsgenauigkeit des in dem Homogenisierungsbereich angeordneten mikroelektronischen Bauelement (36) gegenüber der Lage dieses Homogenisierungsbereichs ist.

6. Mikroelektromechanische Vorrichtung nach einem der Ansprüche 1 bis 5, **dadurch gekennzeichnet, dass** das Biegeelement (4) eine Membran, eine Platte, ein Balken oder eine Scheibe ist.

7. Mikroelektromechanische Vorrichtung nach einem der Ansprüche 1 bis 6, **dadurch gekennzeichnet, dass** das Biegeelement (4) durch Ätzung des Substrats, insbesondere DRIE- oder Plasma-Ätzung ausgebildet ist.

8. Mikroelektromechanische Vorrichtung nach einem der Ansprüche 1 bis 7, **dadurch gekennzeichnet, dass** die Abnahme der Breite des Steges (8) kontinuierlich, quasi kontinuierlich, abschnittsweise kontinuierlich oder stufenweise erfolgt und/oder dass eine den Verlauf eines Seitenrandes des Steges (8) beschreibende Funktion linear, quadratisch, exponentiell, stetig, monoton, differenzierbar, abschnittsweise stetig, abschnittsweise monoton oder abschnittsweise differenzierbar ist.

9. Mikroelektromechanische Vorrichtung nach einem der Ansprüche 1 bis 8, **dadurch gekennzeichnet, dass** der Verlauf beider Seitenränder des Steges (8) bezogen auf eine in seiner Längenerstreckung verlaufende Mittellinie symmetrisch ist.

10. Verwendung einer Vorrichtung nach einem der vorhergehenden Ansprüche als Drucksensor, Beschleunigungssensor oder Resonator.

## Claims

1. A micro-electromechanical device comprising
- a substrate (1) suitable for the production of microelectronic components, in particular a semiconductor substrate,
- a micromechanical component integrated into the substrate (1), said micromechanical component comprising a bending element (4) which can be bent reversibly and which has a first end (34) connected to the substrate (1) and extends from said first end (34) over a free space (3),
- said bending element (4) comprising at least one web (8) having two side edges, the course (35) of said side edges being defined by depressions (6) introduced into the bending element (4) and adjacent to said side edges, and
- wherein the mutual spacing of the side edges of the web (8) decreases, as viewed from the first end (34) of the bending element (4), and
- at least one microelectronic component (36) sensitive to mechanical stresses,
**characterized in**
- **that** the mutual spacing of the side edges of the web (8) decreases, as viewed from the first end (34) of the bending element (4) in order to form a homogenization region located within the web (8), in which mechanical stresses occurring during bending of the bending element (4) are substantially equal, and
- **that** said at least one microelectronic component (36) sensitive to mechanical stresses is integrated within the homogenization region of the web (8).

2. The micro-electromechanical device according to claim 1, **characterized in that** said homogenization region is enlarged in the width and length extension of the web (8).

3. The micro-electromechanical device according to claim 1 or 2, **characterized in that** the microelectronic component (36) is arranged completely within the homogenization region of the web (8).

4. The micro-electromechanical device according to any one of claims 1 to 3, **characterized in that** the homogenization region in the width and/or length extension of the web (8) is by a presettable minimum factor larger than the extension of the microelectronic component (36) in the respective width and/or length direction of the web (8).

5. The micro-electromechanical device according to claim 4, **characterized in that** said factor is at least six sigma, wherein sigma is the positioning accuracy, defined by the process for production of microelectronic components, of the microelectronic component (36) arranged in the homogenization region relative to the position of this homogenization region.

6. The micro-electromechanical device according to any one of claims 1 to 5, **characterized in that** the bending element (4) is a membrane, a plate, a beam or a disk.

7. The micro-electromechanical device according to any one of claims 1 to 6, **characterized in that** the bending element (4) is formed by etching the substrate, preferably by DRIE- or plasma etching.

8. The micro-electromechanical device according to any one of claims 1 to 7, **characterized in that** the decrease of the width of the web (8) is continuous, quasi-continuous, or continuous in a portion-wise or stepped manner, and/or that a function describing the development of a lateral edge of the web (8) is linear, quadratic, exponential, steady, monotonic, differentiable, steady in a portion-wise manner, monotonic in a portion-wise manner, or differentiable in a portion-wise manner.

9. The micro-electromechanical device according to any one of claims 1 to 8, **characterized in that** the development of both lateral edges of the web (8) relative to a central line extending in the longitudinal direction of the web is symmetric.

10. Use of a device according to any one of the preceding claims as a pressure sensor, acceleration sensor or resonator.

## Revendications

1. Dispositif microélectromécanique, comprenant :
- un substrat (1), en particulier un substrat semi-conducteur, approprié pour la fabrication de composants microélectroniques,
- un composant micromécanique intégré dans le substrat (1), qui présente un élément de flexion (4) pouvant être fléchi de manière réversible, lequel présente une première extrémité (34) reliée au substrat (1) et s'étend à partir de cette première extrémité (34) à travers un espace vide (3),
- l'élément de flexion (4) présentant au moins une nervure (8) pourvue de deux bords latéraux dont le tracé (35) est défini par des évidements (6) adjacents aux bords latéraux, pratiqués dans l'élément de flexion (4), et
- la distance mutuelle entre les bords latéraux de la nervure (8) vue de la première extrémité (34) de l'élément de flexion (4) allant diminuant, et
- au moins un composant microélectronique (36) sensible aux tensions mécaniques,
**caractérisé en ce que**
- la distance mutuelle entre les bords latéraux de la nervure (8) vue de la première extrémité (34) de l'élément de flexion (4) diminue pour former une zone d'homogénéisation située à l'intérieur de la nervure (8), dans laquelle des tensions mécaniques survenant lors de la flexion de l'élément de flexion (4) sont sensiblement égales, et
- **en ce que** le au moins un composant microélectronique (36) sensible aux tensions mécaniques est intégré à l'intérieur de la zone d'homogénéisation de la nervure (8).

2. Dispositif microélectromécanique selon la revendication 1, **caractérisé en ce que** la zone d'homogénéisation s'étend dans le sens de la largeur ou de la longueur de la nervure (8).

3. Dispositif microélectromécanique selon la revendication 1 ou 2, **caractérisé en ce que** le composant microélectronique (36) est disposé intégralement à l'intérieur de la zone d'homogénéisation de la nervure (8).

4. Dispositif microélectromécanique selon l'une des revendications 1 à 3, **caractérisé en ce que** la zone d'homogénéisation, dans le sens de la largeur et/ou de la longueur de la nervure (8), est plus grande d'un facteur minimal prédéterminable que l'étendue du composant microélectronique (36) dans le sens de la largeur et/ou de la longueur correspondante de la nervure (8).

5. Dispositif microélectromécanique selon la revendication 4, **caractérisé en ce que** le facteur est d'au moins six Sigma, Sigma indiquant la précision du positionnement, définie par le procédé de fabrication de composants microélectroniques, du composant microélectronique (36) disposé dans la zone d'homogénéisation par rapport à la position de cette zone d'homogénéisation.

6. Dispositif microélectromécanique selon l'une des revendications 1 à 5, **caractérisé en ce que** l'élément de flexion (4) est un diaphragme, une plaque, une poutre ou un disque.

7. Dispositif microélectromécanique selon l'une des revendications 1 à 6, **caractérisé en ce que** l'élément de flexion (4) est configuré par attaque du substrat, en particulier une attaque au DRIE ou au plasma.

8. Dispositif microélectromécanique selon l'une des revendications 1 à 7, **caractérisé en ce que** la réduction de la largeur de la nervure (8) s'opère de manière continue, quasi continue, partiellement continue ou de manière progressive et/ou **en ce qu'**une fonction décrivant le tracé d'un bord latéral de la nervure (8) est linéaire, quadratique, exponentielle, continue, monotone, différenciable, partiellement continue, partiellement monotone ou partiellement différenciable.

9. Dispositif microélectromécanique selon l'une des revendications 1 à 8, **caractérisé en ce que** le tracé des deux bords latéraux de la nervure (8) est symétrique par rapport à un axe s'étendant dans la direction longitudinale de celle-ci.

10. Utilisation d'un dispositif selon l'une des revendications précédentes en tant que capteur de pression, capteur d'accélération ou résonateur.
